# EUROPEAN PATENT APPLICATION

(11) **EP 4 615 171 A1**
(43) Date of publication of application: **10.09.2025**
(21) Application number: 25161778.3
(22) Date of filing: 05.03.2025
(51) Int. Cl.: H05K 1/02, H05K 1/18, H05K 1/11, H05K 9/00

(54) **GROUNDING OF INTEGRATED EXTERNAL EMI SHIELD OF AN OPTICAL SENSOR MODULE**

(30) Priority: 08.03.2024 US 202418600362
(71) Applicant: STMicroelectronics International N.V., 1228 Plan-les-Ouates, Geneva (CH)
(72) Inventor: CHENG, Kai Quan, 563588 SINGAPORE (SG); TEO, Tat Ming, 797463 SINGAPORE (SG); MAO, Yandong, SHANGHAI, 200240 (CN)
(74) Representative: Casalonga

(57) **Abstract**

Methods and systems for grounding of integrated external electromagnetic interference (EMI) shields are provided. A portion of a module substrate 102 protrudes on at least one side of the module 100A. The protruding portion of the module substrate comprises one or more grounding pads 103a...N to which the EMI shield 101 is grounded. The EMI shield may cover at least a portion of the thickness of the module substrate. The EMI shield may be comprised of one or more parts, which may be coupled to one another. The module substrate may include conductive vias. The EMI shield may include a sprayed and/or printed coating. The EMI shield may include a darkened coating.

## Description

### TECHNOLOGICAL FIELD

Example embodiments of the present disclosure relate generally to grounding of integrated external electromagnetic interference (EMI) shields.

### BACKGROUND

Electromagnetic interference shielding creates a Faraday cage effect which attenuates radiation of electromagnetic (EM) waves and/or prevents EM emissions from circuit components such as optical sensors from being emitted outside of the circuit board. Conductive metal cans, commonly fabricated through stamping and/or drawing sheets of metallic material, create a conductive envelopment around the host circuit board containing the optical sensor. These conventional manners of manufacturing, including circuit board level metal can shielding may introduce issues such as an increase in overall footprint of the shielded circuit board. Due to the manufacturing process of stamped metal sheet cans, there is a minimum radius of the corner of the cans, which increases the footprint of the EMI shield. Additionally, using multiple metal cans to cover irregularly shaped components can introduce points through which EM waves may leak, particularly at higher frequencies. Circuit board level metal can shielding, in some examples, does not prevent internal EMI crosstalk between components within the same EMI shield. Additionally, using circuit board level shielding incurs costs in terms of quality assurance to ensure proper assembly and grounding, the process of assembling the shields, and material costs for shielding elements.

The inventors have identified numerous areas of improvement in the existing technologies and processes, which are the subjects of embodiments described herein. Through applied effort, ingenuity, and innovation, many of these deficiencies, challenges, and problems have been solved by developing solutions that are included in embodiments of the present disclosure, some examples of which are described in detail herein.

### BRIEF SUMMARY

Various embodiments described herein relate to an improved assembly and grounding of integrated external EMI shields (e.g., for optical sensor modules).

In accordance with some embodiments of the present disclosure, an example method of assembling and grounding integrated external EMI shields is provided. The method may comprise assembling a module comprising a module substrate, the module substrate protruding on at least one side of the module, wherein the protruding portion of the module substrate comprises one or more grounding pads; and coupling an EMI shield comprising at least one shield component to the module.

In some embodiments, the method may comprise applying an adhesive to the module for adhering the EMI shield to the module; and curing the adhesive.

In some embodiments, the module substrate protrudes on one side of the module, wherein the protruding portion of the module substrate comprises two or more discrete grounding pads.

In some embodiments, the EMI shield comprises discrete cutouts for preventing jetted solder from expanding beyond a desired thickness.

In some embodiments, the method may comprise applying jetted solder to the one or more grounding pads of the module substrate.

In some embodiments, the module substrate protrudes on one side of the module, wherein the protruding portion of the module substrate comprises one elongated grounding pad.

In some embodiments, the method may comprise applying conductive adhesive to the one elongated grounding pad to create a conductive connection between the module substrate and the EMI shield; and curing the conductive adhesive.

In some embodiments, the method may comprise applying solder paste to the one elongated grounding pad to create a conductive connection between the module substrate and the EMI shield; and reflowing the solder paste.

In some embodiments, the module substrate protrudes on all sides of the perimeter of the module, wherein the protruding portions of the module substrate comprise a perimeter grounding pad.

In some embodiments, the method may comprise applying conductive adhesive to the perimeter grounding pad to create a conductive connection between the module substrate and the EMI shield; and curing the conductive adhesive.

In some embodiments, the method may comprise applying solder paste to the perimeter grounding pad to create a conductive connection between the module substrate and the EMI shield; and reflowing the solder paste.

In some embodiments, the module substrate comprises one or more grounding pads on an underside of the module substrate.

In some embodiments, the method may comprise applying conductive adhesive to the one or more grounding pads on the underside of the module substrate; coupling a bottom EMI shield component to the module via the one or more grounding pads; curing the conductive adhesive; and coupling a top EMI shield component to the bottom EMI shield component.

In some embodiments, the coupling the top EMI shield component to the bottom EMI shield component comprises using mechanical coupling.

In some embodiments, the module substrate comprises conductive vias and wherein the conductive vias surround the perimeter of the module substrate.

In some embodiments, the module substrate comprises conductive vias and wherein the conductive vias are dispersed throughout the module substrate.

In some embodiments, the method may comprise applying masking to areas determined to remain free of coating; spraying the EMI shield with a conductive coating such that the conductive coating grounds the EMI shield to the one or more grounding pads; removing the masking; and curing the conductive coating.

In some embodiments, the method may comprise printing a conductive coating on the EMI shield; applying conductive adhesive to the one or more grounding pads; and curing the conductive adhesive.

In some embodiments, the method may comprise printing a conductive coating on the EMI shield; applying solder paste to the one or more grounding pads; and reflowing the solder paste.

In some embodiments, the method may comprise using a darkened EMI shield, wherein the darkened EMI shield is comprised of at least one of: nickel-phosphorous; oxidized nickel; graphene; or dark-painted material.

The above summary is provided merely for purposes of summarizing some example embodiments to provide a basic understanding of some aspects of the disclosure. Accordingly, it will be appreciated that the above-described embodiments are merely examples and should not be construed to narrow the scope of the disclosure in any way. It will also be appreciated that the scope of the disclosure encompasses many potential embodiments in addition to those here summarized, some of which will be further described below.

### BRIEF SUMMARY OF THE DRAWINGS

Having thus described certain example embodiments of the present disclosure in general terms, reference will now be made to the accompanying drawings, which are not necessarily drawn to scale, and wherein:
FIG. 1A illustrates a perspective view of an exemplary EMI shield having cutouts in accordance with one or more embodiments of the present disclosure.
FIG. 1B illustrates a head-on view of an exemplary EMI shield having cutouts in accordance with one or more embodiments of the present disclosure.
FIG. 2 illustrates an exemplary method of assembling a module comprising an EMI shield having cutouts in accordance with one or more embodiments of the present disclosure.
FIG. 3A illustrates a perspective view of an exemplary module comprising an EMI shield grounded using an elongated grounding pad in accordance with one or more embodiments of the present disclosure.
FIG. 3B illustrates a cross-sectional view of an exemplary module comprising an EMI shield grounded using an elongated grounding pad in accordance with one or more embodiments of the present disclosure.
FIG. 4A illustrates an exemplary method of assembling a module comprising an EMI shield grounded using an elongated grounding pad and conductive adhesive in accordance with one or more embodiments of the present disclosure.
FIG. 4B illustrates an exemplary method of assembling a module comprising an EMI shield grounded using an elongated grounding pad and solder in accordance with one or more embodiments of the present disclosure.
FIG. 5A illustrates an exemplary method of assembling a module comprising a protruding perimeter of the module substrate and corresponding perimeter grounding pads using solder in accordance with one or more embodiments of the present disclosure.
FIG. 5B illustrates an exemplary method of assembling a module comprising a protruding perimeter of the module substrate and corresponding perimeter grounding pads using conductive adhesive in accordance with one or more embodiments of the present disclosure.
FIG. 6 illustrates an exemplary method of assembling a module comprising a multi-part EMI shield in accordance with one or more embodiments of the present disclosure.
FIG. 7A illustrates a perspective view of an exemplary substrate comprising conductive vias surrounding its perimeter in accordance with one or more embodiments of the present disclosure.
FIG. 7B illustrates a cross-sectional perspective view of an exemplary substrate comprising conductive vias connected to the ground plane which extends across the thickness of the substrate and surrounding the perimeter of the substrate in accordance with one or more embodiments of the present disclosure.
FIG. 8 illustrates an exemplary method of applying a conductive coating to a module comprising an elongated grounding pad in accordance with one or more embodiments of the present disclosure.
FIG. 9 illustrates an exemplary method of applying a conductive coating to a module comprising an elongated grounding pad in accordance with one or more embodiments of the present disclosure.
FIG. 10 illustrates a perspective view of an exemplary EMI shield comprising a coated cap component and an elongated grounding pad in accordance with one or more embodiments of the present disclosure.
FIG. 11 illustrates a perspective view of an exemplary EMI shield comprising a coated cap component and discrete grounding pads in accordance with one or more embodiments of the present disclosure.
FIG. 12 illustrates a perspective view of an exemplary EMI shield comprising at least a darkened portion in accordance with one or more embodiments of the present disclosure.
FIGS. 13A-13K illustrate example flowcharts of operations for assembling modules with EMI shielding in accordance with one or more embodiments of the present disclosure.

### DETAILED DESCRIPTION

Some embodiments of the present disclosure will now be described more fully herein with reference to the accompanying drawings, in which some, but not all, embodiments of the disclosure are shown. Indeed, various embodiments of the disclosure may be embodied in many different forms and should not be construed as limited to the embodiments set forth herein; rather, these embodiments are provided so that this disclosure will satisfy applicable legal requirements. Like reference numerals refer to like elements throughout.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in various embodiments," "in one embodiment," "according to one embodiment," "in some embodiments," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments or it may be excluded.

### Overview

Various embodiments of the present disclosure are directed to improved EMI shielding and grounding thereof. Various embodiments may include EMI shields, which may be comprised of metal cans, plastic cans, and/or other materials. Various embodiments may include EMI shielding for modules such as optical modules.

Various embodiments may include using a portion of the optical module substrate, different from the circuit board substrate, which protrudes past the optical module as a location for grounding pad(s) to which the EMI shield is grounded. Various embodiments may include the EMI shield (e.g., use of a metal can, injection moulding of plastic embedded with electrically conductive fillers, use of electrically conductive foam sheets, etc.) covering at least a portion of the thickness of the optical module substrate, which may attenuate EM radiation that may leak out through the substrate thickness itself. Various embodiments may include a multi-part (e.g., at least a two-part) metal can which couple to one another and are grounded to the to the underside of the optical module substrate. In various embodiments, the underside of the optical module substrate is the side opposite the side which comprises the optical module. Various embodiments may include a plurality of conductive vias within the perimeter of the optical module substrate, which may attenuate EM radiation that may leak out through the substrate thickness itself. Various embodiments may include an EMI shield comprising a sprayed and/or printed conductive coating, which may be directly applied to the module and/or to a can.

The present disclosure, in some examples, includes a number of advantages, including creating stronger solder joints via cutouts preventing solder from spreading beyond a desired thickness, attenuating EMI leakage from the substrate thickness itself via overhanging portions of EMI shields, grounding EMI shields for EMI mitigation, attenuating EMI leakage from the substrate thickness itself via plated vias dispersed throughout the module substrate (e.g., surrounding the perimeter of the module substrate), reducing optical crosstalk via using darkened and/or blackened coatings, and/or other advantages.

### Exemplary Systems and Apparatuses

Embodiments of the present disclosure herein include systems and apparatuses for improvement of EMI shielding and grounding thereof which are described herein and may be implemented in various embodiments.

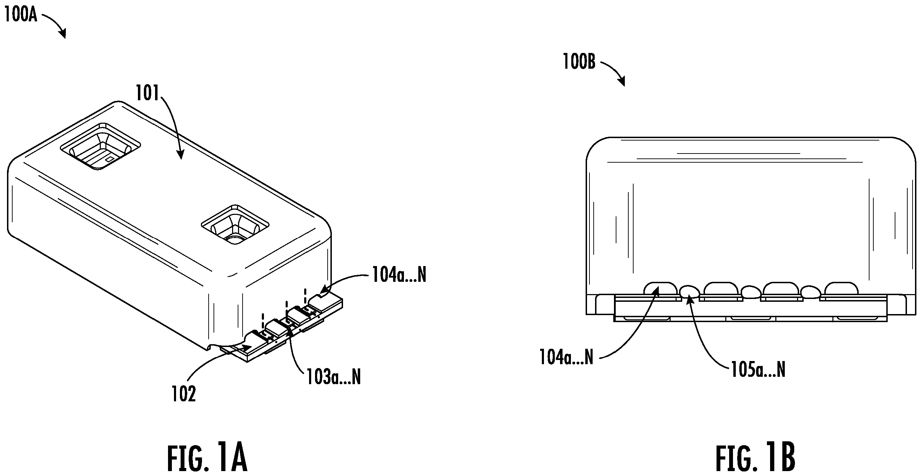

FIG. 1A illustrates a perspective view of an exemplary EMI shield having cutouts in accordance with one or more embodiments of the present disclosure. FIG. 1A shows a module 100A, which may comprise EMI shield 101, optical module substrate 102, grounding pads 103a...N, and cutouts 104a...N. In various embodiments, the EMI shield 101 may be metal. In various embodiments, a protruding portion of the module substrate 102 may comprise the grounding pads 103a...N. In various embodiments, the grounding pads 103a...N are discrete grounding pads. For example, the discrete grounding pads may be "small" (e.g., relative to the EMI shield and the module as a whole). For example, the discrete grounding pad may range in size (e.g., preferably approximately two hundred microns in width and length). In various embodiments, the cutouts 104a...N are discrete cutouts. For example, the discrete cutouts may correspond in size to the discrete grounding pads.

FIG. 1B illustrates a head-on view of an exemplary EMI shield having cutouts in accordance with one or more embodiments of the present disclosure. FIG. 1B shows a module 100B, which may comprise a head-on view of the cutouts 104a...N and solder 105a...N (e.g., solder balls). The solder 105a...N may be jetted solder and/or may be otherwise applied. In various embodiments, the cutouts 104a...N on the EMI shield 101 may allow for localized dispersion of the jetted solder 105a...N, for example, preventing the jetted solder from spreading beyond the confines of the cutouts 104a...N and becoming too thin, thereby mitigating potential solder crack issues. In various embodiments, the EMI shield 101 may extend down at least a portion of the thickness of the module substrate (e.g., overhanging the sides of the module substrate), which may allow the EMI shield to attenuate EMI leakage from the thickness of the substrate itself. For example, the EMI shield may extend down the thickness of the substrate on three of the four sides of the module substrate.

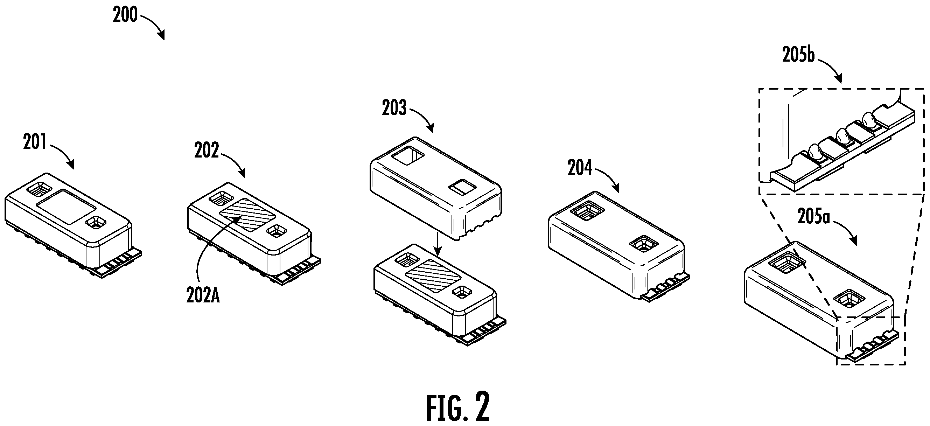

FIG. 2 illustrates an exemplary method 200 of assembling a module comprising an EMI shield having cutouts in accordance with one or more embodiments of the present disclosure. FIG. 2 illustrates the method 200 for assembling a module comprising an EMI shield having cutouts, such as those shown in FIGS. 1A-1B. The method 200 shows the assembled module at 201, the module with an attached adhesive (e.g., can glue) at 202, attaching the EMI shield at 203, curing the adhesive at 204, solder jetting at 205a, and a blown-up view 205b of the solder jetting of 205a. In various embodiments, the cutouts 104a...N allow for a stronger solder joint by preventing the jetted solder 105a...N from expanding beyond a desired thickness.

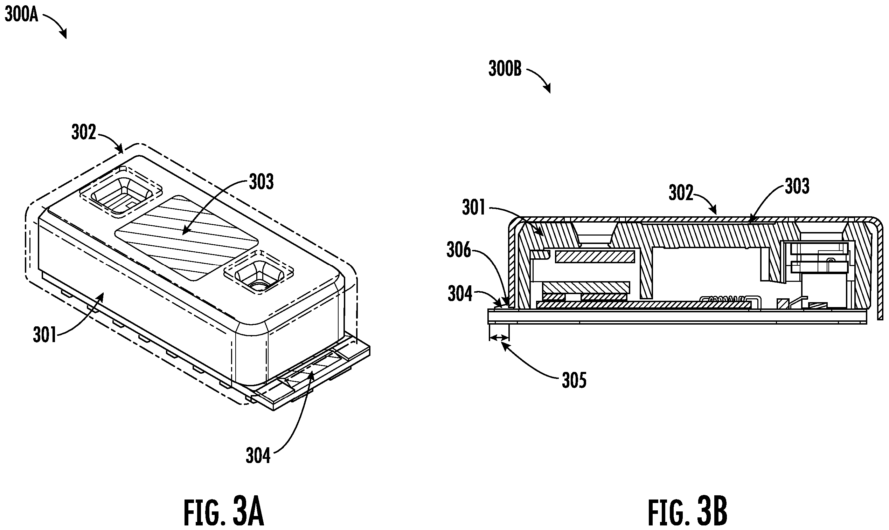

FIG. 3A illustrates a perspective view of an exemplary module comprising an EMI shield grounded using an elongated grounding pad in accordance with one or more embodiments of the present disclosure. FIG. 3A shows a module 300A, which may comprise an optical module 301, an EMI shield 302, adhesive 303, and a grounding pad 304 (e.g., with adhesive). In various embodiments, the EMI shield 302 may extend down at least a portion of the thickness of the module substrate, which may allow the EMI shield to attenuate EMI leakage from the thickness of the substrate itself. For example, the EMI shield may extend down the thickness of the substrate on three of the four sides of the module substrate. The adhesive 303 may allow for attaching the EMI shield 302 to the optical module 301.

FIG. 3B illustrates a cross-sectional view of an exemplary module comprising an EMI shield grounded using an elongated grounding pad in accordance with one or more embodiments of the present disclosure. FIG. 3B shows a module 300B, which is a cross-sectional view of the module 300A. The module 300B shows the optical module 301, the EMI shield 302, the adhesive 303, the grounding pad 304, conductive adhesive 306 and a protruding portion of module substrate 305. The protruding portion of the module substrate 305 may comprise at least one grounding pad (e.g., one elongated grounding pad). For example, the elongated grounding pad may be "large" relative to the size of the EMI shield and/or the module. For example, the elongated grounding pad may approximately correspond in size to the width of the EMI shield. For example, the conductive adhesive 306 (e.g., a silver-based adhesive, etc.) may be used to electrically couple the EMI shield 302 to the grounding pad 304.

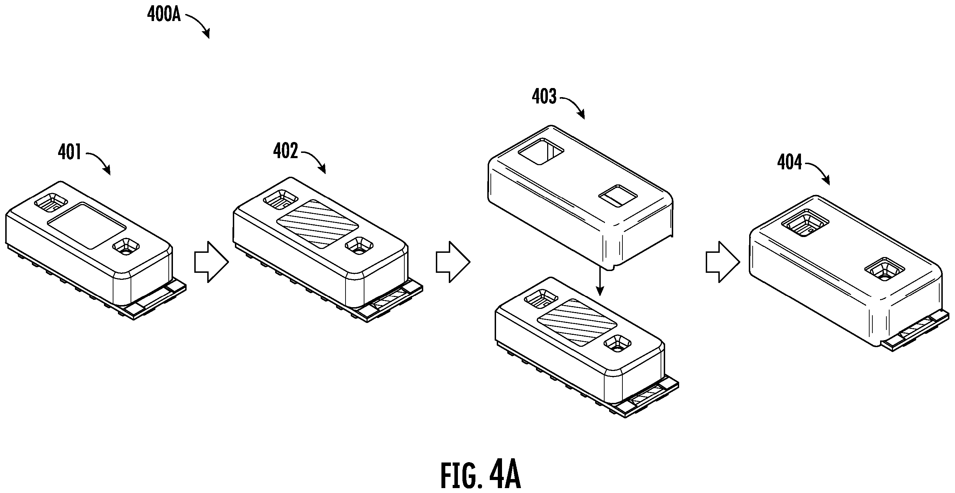

FIG. 4A illustrates an exemplary method 400A of assembling a module comprising an EMI shield grounded using an elongated grounding pad and conductive adhesive in accordance with one or more embodiments of the present disclosure. FIG. 4A illustrates the method 400A for assembling a module comprising an EMI shield and an elongated grounding pad with conductive adhesive, such as those shown in FIGS. 3A-3B. The method 400A shows an assembled module at 401, dispensed adhesive for attaching the EMI shield 302 onto the top of the module 401 in provisioned glue pockets and dispensed conductive adhesive onto the protruded substrate grounding pad 304 at 402, attaching the EMI shield at 403, and curing the adhesives at 404.

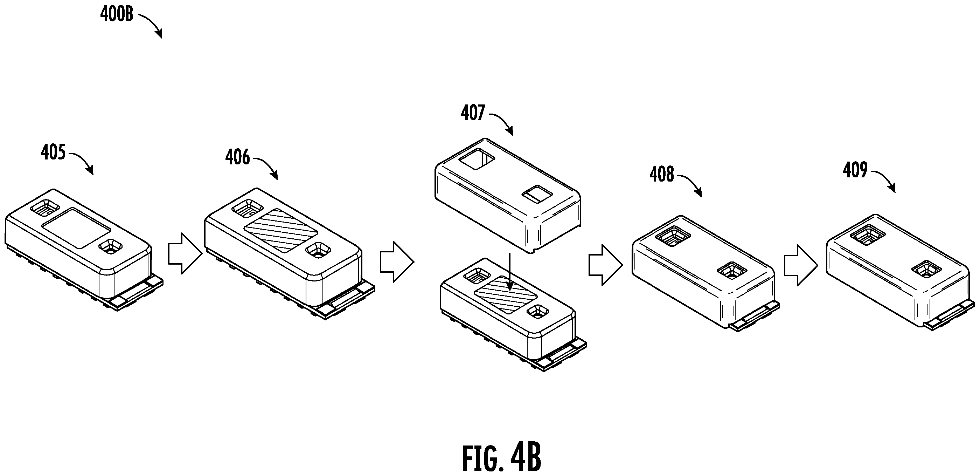

FIG. 4B illustrates an exemplary method 400B of assembling a module comprising an EMI shield grounded using an elongated grounding pad and solder in accordance with one or more embodiments of the present disclosure. FIG. 4B illustrates the method 400B for assembling a module comprising an EMI shield and an elongated grounding pad with solder, such as those shown in FIGS. 3A-3B. The method 400B shows an assembled module at 405, dispense adhesive for attaching the EMI shield 302 onto the top of the module 401 in provisioned glue pockets and dispense solder paste onto the protruded substrate grounding pad 304 at 406, attaching the EMI shield at 407, curing the adhesive at 408, and reflowing the dispensed solder paste at 409.

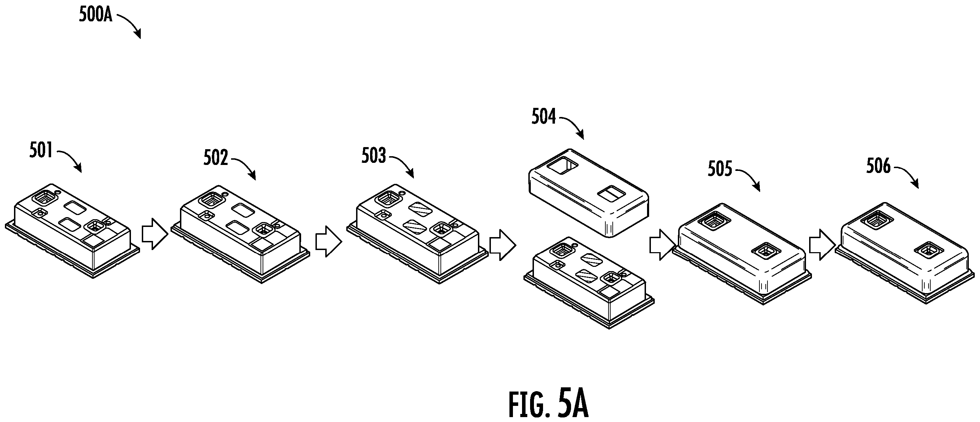

FIG. 5A illustrates an exemplary method 500A of assembling a module comprising a protruding perimeter of the module substrate and corresponding perimeter grounding pads using solder paste in accordance with one or more embodiments of the present disclosure. The method 500A shows an assembled module with a protruding perimeter of the module substrate and corresponding perimeter grounding pad(s) at 501, dispensing solder paste on the grounding pad(s) at 502, dispensing adhesive into pockets provisioned on the top of the module to attach the EMI shield on the module at 503, attaching the EMI shield at 504, curing the adhesive at 505, and reflowing solder paste at 506.

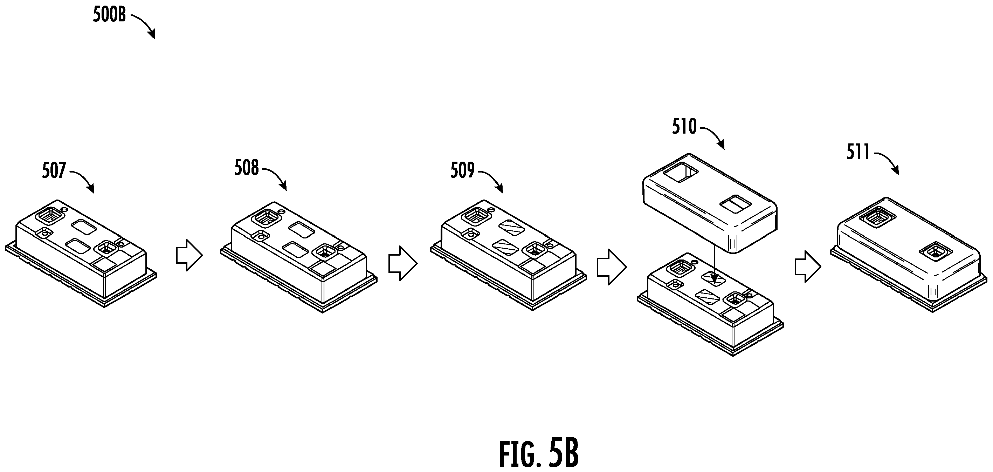

FIG. 5B illustrates an exemplary method 500B of assembling a module comprising a protruding perimeter of the module substrate and corresponding perimeter grounding pads using conductive adhesive in accordance with one or more embodiments of the present disclosure. The method 500B shows an assembled module with a protruding perimeter of the module substrate and corresponding perimeter grounding pad(s) at 507, dispensing conductive adhesive onto the perimeter grounding pads at 508, dispensing adhesive into adhesive pockets on the top of the module for attaching the EMI shield to the module at 509, attaching the EMI shield at 510, and curing the adhesives at 511.

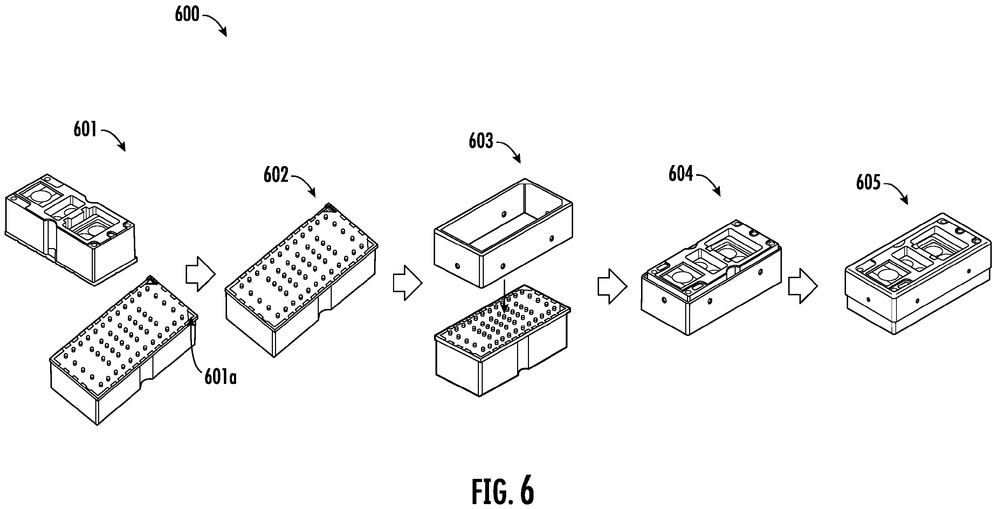

FIG. 6 illustrates an exemplary method of assembling a module comprising a multi-part EMI shield in accordance with one or more embodiments of the present disclosure. The method 600 shows an assembled module at 601 with grounding pads 601a (e.g., at the corners of the underside of the substrate), dispensing conductive adhesive on the grounding pads 601a at 602, coupling the bottom portion of EMI shield to module at 603, curing the conductive adhesive at 604, and coupling the top portion of EMI shield to the bottom portion at 605. The multi-part EMI shield may be comprised of two or more parts. In various embodiments, the multi-part EMI shield may be comprised of two parts. In various embodiments, the first portion of the EMI shield (e.g., the bottom portion) may be placed on the underside of the assembled module. In various embodiments, the underside of the optical module substrate is the side opposite the side which comprises the optical module. In various embodiments, the second portion of the EMI shield (e.g., the top portion) may be placed over the top side of the module, which may form a complete enveloped EMI shielded module. In various embodiments, the top side of the module is the side which comprises the optical module. In various embodiments, the two or more portions of the EMI shield may be variously coupled to one another, for example, they may be mechanically coupled to one another. In various embodiments, to facilitate grounding of the EMI shield (e.g., a metal can), the optical module substrate may include grounding pads such as the grounding pads 601a, which may be variously located (e.g., on the underside of the module substrate). In various embodiments, conductive adhesive may be dispensed onto the grounding pads 601a before coupling the module to the first portion of the EMI shield. In various embodiments, the conductive adhesive may contact the grounding pads 601a of the module substrate to the EMI shield which may achieve grounding for EMI mitigation.

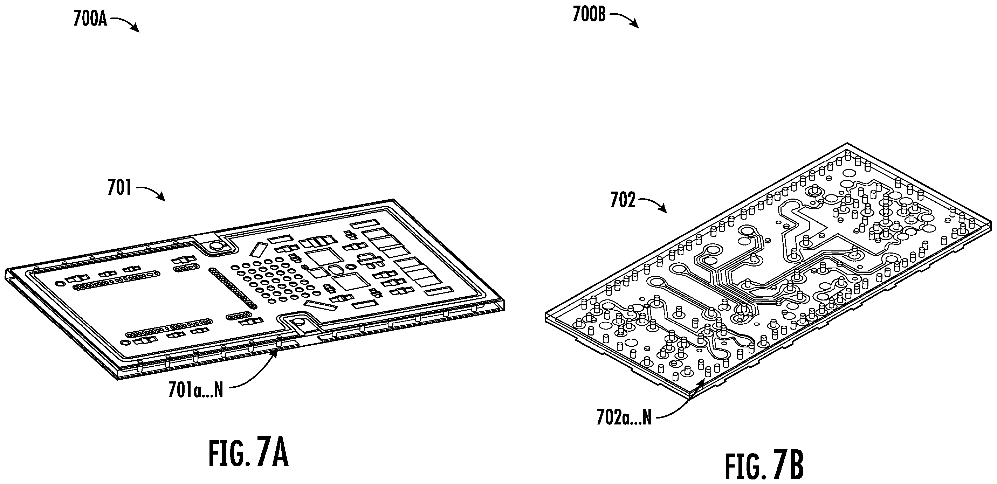

FIG. 7A illustrates a perspective view of an exemplary substrate comprising conductive vias surrounding its perimeter in accordance with one or more embodiments of the present disclosure. The exemplary substrate 700A shows a module substrate 701 and conductive vias 701a...N surrounding the perimeter of the module substrate 701. In various embodiments, the perimeter vias 701a...N may be plated vias. In various embodiments, the perimeter vias 701a...N, when coupled to the ground of the module (e.g., grounding pads), may provide a conductive barrier against electromagnetic waves escaping through the thickness of the module substrate 701 itself. In various embodiments, perimeter vias may be combined with any other EMI shielding method to provide a complete EMI shield around the module, for example, such as the EMI shielding methods described herein (e.g., the EMI shielding methods of FIGS. 1A-6 and FIGS. 8-12).

FIG. 7B illustrates a cross-sectional perspective view of an exemplary substrate comprising conductive vias that are connected to the ground plane of the substrate and span the perimeter of the substrate. The exemplary substrate 700B shows a module substrate 702 and conductive vias 702a...N which surround the perimeter of the module substrate 702. In various embodiments, the vias 702a...N may be plated vias which extend across the entire thickness of the substrate and are electrically connected to the substrate ground. In various embodiments, the vias 702a...N, when coupled to the ground of the module (e.g., grounding pads), may provide a conductive barrier against electromagnetic waves escaping through the thickness of the module substrate 702 itself. In various embodiments, vias may be combined with any other EMI shielding method, for example, such as the EMI shielding methods described herein. In various embodiments, the vias 702a...N may be perimeter vias such as those described with respect to FIG. 7A. In various embodiments, plated vias may be combined with any other EMI shielding method, for example, such as the EMI shielding methods described herein (e.g., the EMI shielding methods of FIGS. 1A-6 and FIGS. 8-12).

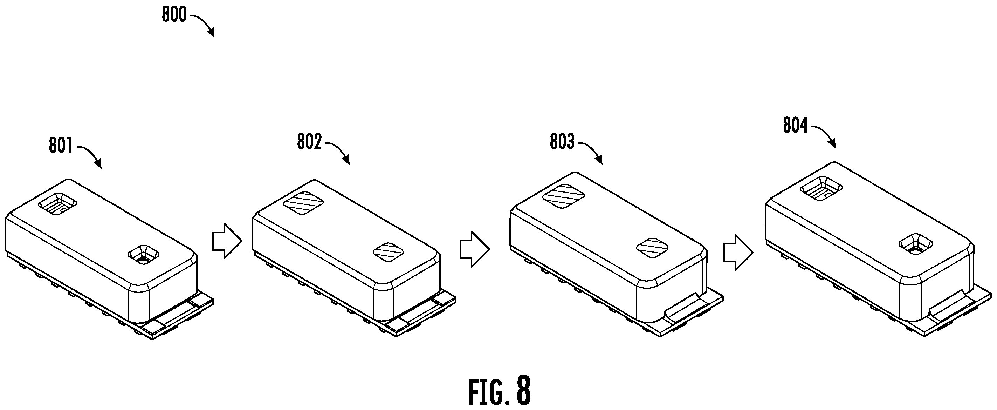

FIG. 8 illustrates an exemplary method 800 of applying a conductive coating to a module comprising an elongated grounding pad in accordance with one or more embodiments of the present disclosure. The method 800 shows an example of spraying and/or printing a conductive coating (e.g., a polymer-based conductive coating) on a module for EMI shielding. The method 800 shows an assembled module with an elongated grounding pad on protruding portion of the module substrate at 801, masking apertures at 802, spraying and/or printing the conductive coating at 803, and masking removal and curing of the conductive coating at 804. In various embodiments, the conductive coating may be sprayed onto the module and/or onto a separate can. In various embodiments, the conductive coating may be printed onto the module and/or onto a separate can. In various embodiments, the spraying and/or printing of the conductive coating may also cover at least a portion of the thickness of the module substrate, which may allow for shielding against electromagnetic waves being emitted from the substrate thickness. In various embodiments, when printing the conductive coating, the printing may skip printing over the apertures/desired areas (e.g., instead of using masking over the apertures). In various embodiments, the sprayed and/or printed coating may be applied to the elongated grounding pad.

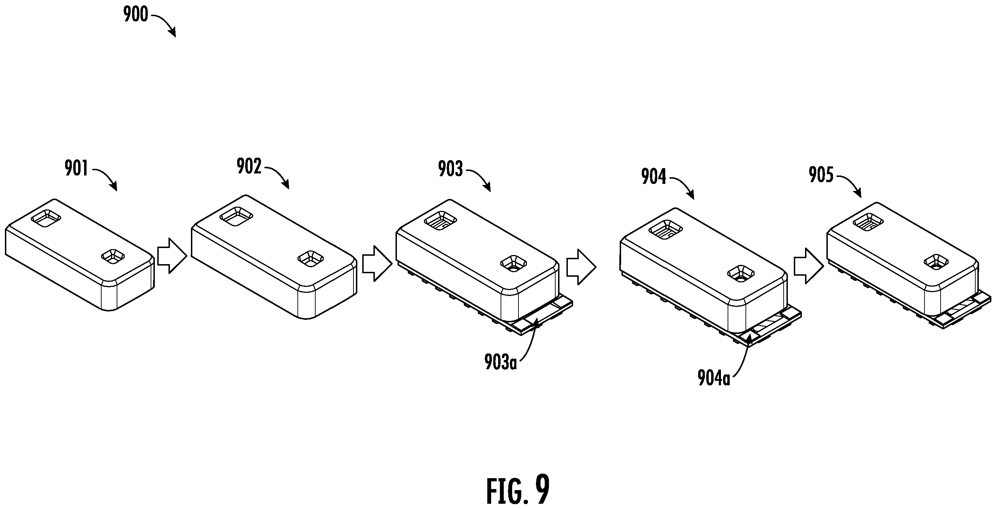

FIG. 9 illustrates an exemplary method 900 of applying a conductive coating to a module comprising an elongated grounding pad in accordance with one or more embodiments of the present disclosure. The method 900 shows a cap component (e.g., the cap component may be comprised of plastic) at 901, coating the cap component (e.g., using electroless plating and/or physical vapor deposition (PVD)) with a conductive material (e.g., copper-nickel), assembling a module with the coated cap component at 903 (wherein the module substrate includes a protruding portion with an elongated grounding pad 903a), applying conductive adhesive and/or solder to grounding pad at 904 such that conductive adhesive and/or solder is also in contact with the coated cap 904a, and curing (e.g., oven curing) and/or reflowing to set the conductive adhesive and/or solder at 905.

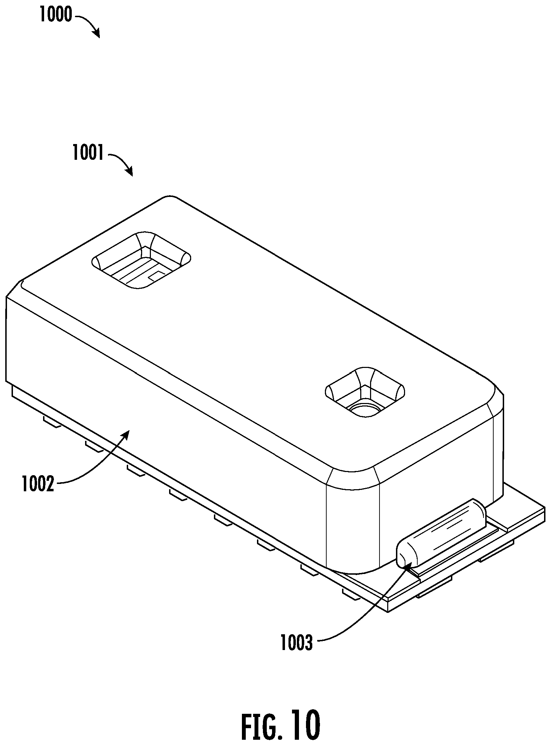

FIG. 10 illustrates a perspective view 1000 of an exemplary EMI shield comprising a coated cap component and an elongated grounding pad in accordance with one or more embodiments of the present disclosure. The perspective view 1000 shows an assembled module 1001 comprising a coated cap 1002 (e.g., the cap may be coated with a metallic material such as copper-nickel via electroless plating and/or PVD, wherein the coating process may involve the use of masks to mask optical openings on the module to ensure coating does not cover these openings hindering the performance of the optical module), and solder paste dispensed on the elongated grounding pad 1003 on a protruding portion of the module substrate. In various embodiments, when the module is reflowed, the solder paste will couple the coated cap to the grounding pad on the module substrate.

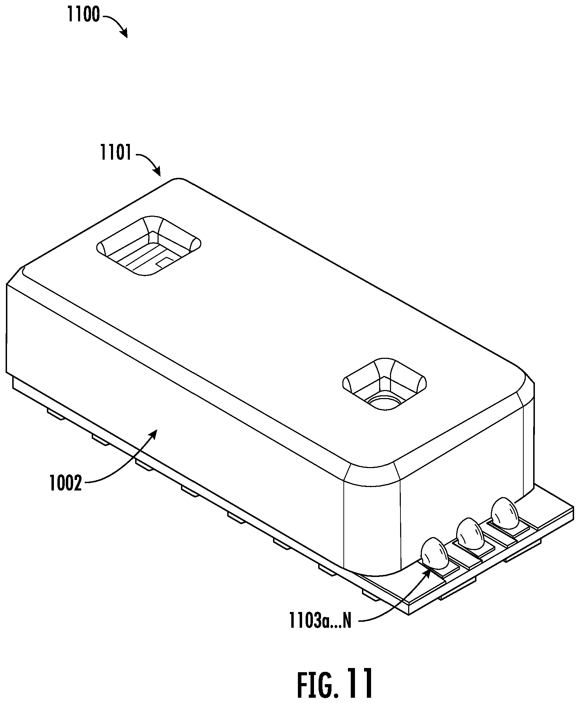

FIG. 11 illustrates a perspective view 1100 of an exemplary EMI shield comprising a coated cap component and discrete grounding pads in accordance with one or more embodiments of the present disclosure. The perspective view 1100 shows an assembled module 1101 comprising a coated cap 1102 (e.g., the cap may be coated with a metallic material such as copper-nickel via electroless plating and/or PVD), and jetted solder 1103a...N dispensed in balls on discrete grounding pads separated by solder mask on a protruding portion of the module substrate. In various embodiments, the discrete grounding pads may be small grounding pads separated by solder mask to prevent jetted solder balls from spreading too wide and/or thin over the region. For example, the small grounding pads may be approximately one hundred microns.

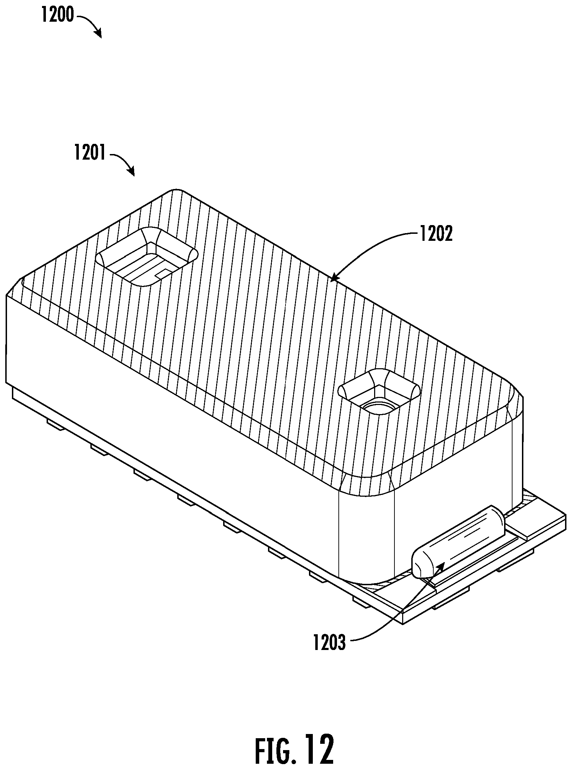

FIG. 12 illustrates a perspective view 1200 of an exemplary EMI shield comprising at least a darkened portion in accordance with one or more embodiments of the present disclosure. The perspective view 1200 shows an assembled module 1201 comprising a cap with a darken to surface 1202, and solder 1203 on an elongated grounding pad on a protruding portion of module substrate. In various embodiments, the darkening may be achieved by painting at least a portion of a conductive coated cap 1002 a dark color (e.g., black), applying a secondary coating which has anti-reflective properties, and/or using darkened/blackened conductive coatings (e.g., oxidized nickel, nickel-phosphorous, graphene, etc.). In various embodiments, the darkened cap may reduce optical crosstalk. A darkened/blackened EMI shield may be used in combination with one or more of the embodiments described herein, which may include darkening the top sides of the assembled EMI shield 101.

It should be readily appreciated that the embodiments of the systems and apparatuses, described herein may be configured in various additional and alternative manners in addition to those expressly described herein.

### Exemplary Methods

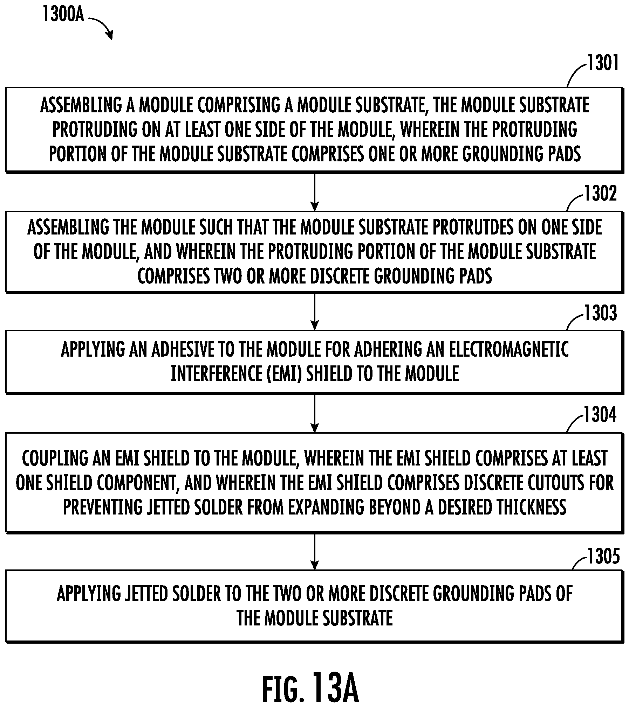

FIGS. 13A-13K illustrate example flowcharts of operations for assembling modules with EMI shielding in accordance with one or more embodiments of the present disclosure.

FIG. 13A illustrates an example flowchart 1300A of operations for assembling a module comprising an EMI shield having cutouts in accordance with one or more embodiments of the present disclosure.

At operation 1301, assembling a module comprising a module substrate may be performed. In various embodiments, the module substrate may protrude on at least one side of the module, wherein the protruding portion of the module substrate may comprise one or more grounding pads.

At operation 1302, assembling the module such that the module substrate protrudes on one side of the module may be performed. In various embodiments, the protruding portion of the module substrate may comprise two or more discrete grounding pads (e.g., the grounding pads 103a...N).

At operation 1303, applying an adhesive to the module may be performed. In various embodiments, the adhesive may allow for adhering an EMI shield to the module. In various embodiments, curing the adhesive may be performed. In various embodiments, the curing may comprise oven curing.

At operation 1304, coupling an EMI shield to the module may be performed. In various embodiments, the EMI shield comprises at least one shield component. In various embodiments, the EMI shield comprises discrete cutouts (e.g., the cutouts 104a...N) for preventing jetted solder from expanding beyond a desired thickness.

At operation 1305, applying jetted solder to the two or more discrete grounding pads of the module substrate may be performed. In various embodiments, the jetted solder may be solder balls (e.g., the solder balls 105a...N).

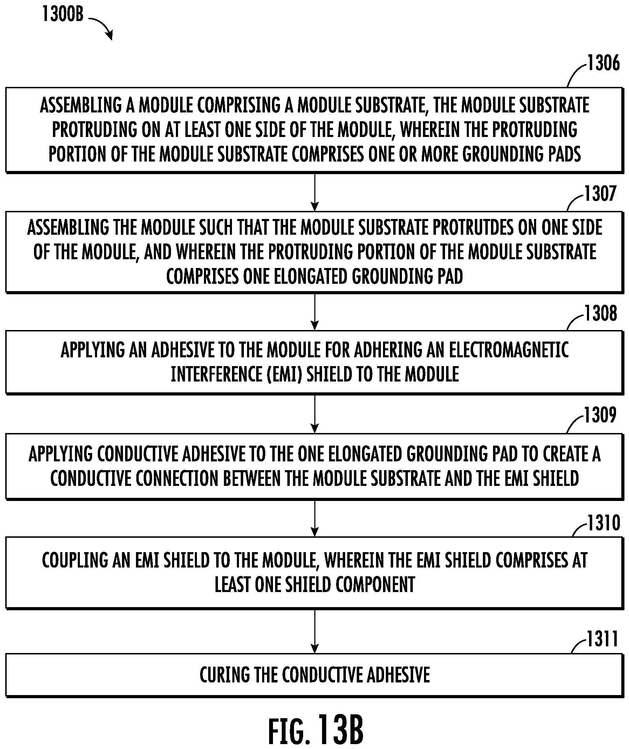

FIG. 13B illustrates an example flowchart 1300B of operations for assembling a module comprising an EMI shield grounded using an elongated grounding pad and conductive adhesive in accordance with one or more embodiments of the present disclosure.

At operation 1306, assembling a module comprising a module substrate may be performed. In various embodiments, the module substrate may protrude on at least one side of the module, wherein the protruding portion of the module substrate may comprise one or more grounding pads.

At operation 1307, assembling the module such that the module substrate protrudes on one side of the module may be performed. In various embodiments, the protruding portion of the module substrate (e.g., protruding portion 305) may comprise one elongated grounding pad (e.g., the grounding pad 304).

At operation 1308, applying an adhesive to the module for adhering an EMI shield to the module may be performed. In various embodiments, curing the adhesive may be performed. In various embodiments, the curing may comprise oven curing.

At operation 1309, applying conductive adhesive to the one elongated grounding pad to create a conductive connection between the module substrate and the EMI shield may be performed.

At operation 1310, coupling an EMI shield to the module may be performed. In various embodiments, the EMI shield may comprise at least one shield component.

At operation 1311, curing the conductive adhesive may be performed. In various embodiments, the curing may comprise oven curing.

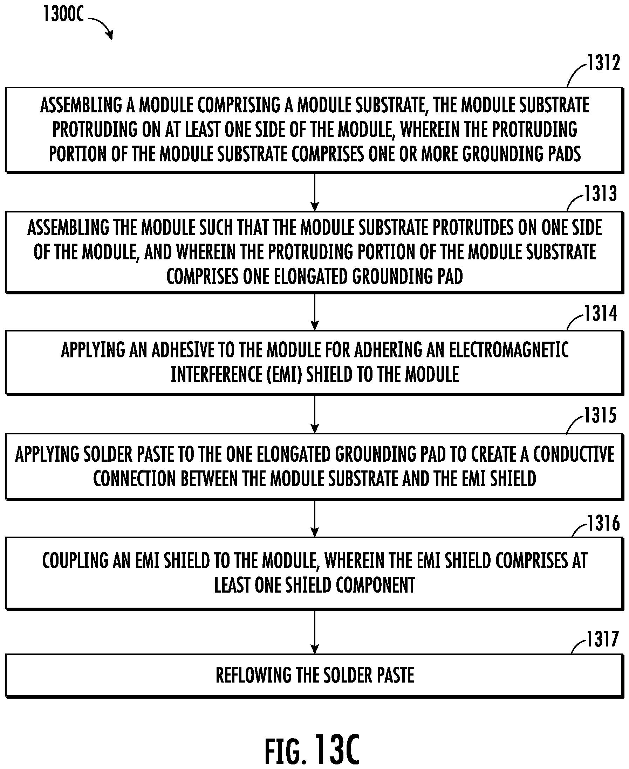

FIG. 13C illustrates an example flowchart 1300C of operations for assembling a module comprising an EMI shield grounded using an elongated grounding pad and solder paste in accordance with one or more embodiments of the present disclosure.

At operation 1312, assembling a module comprising a module substrate may be performed. In various embodiments, the module substrate may protrude on at least one side of the module, wherein the protruding portion of the module substrate may comprise one or more grounding pads.

At operation 1313, assembling the module such that the module substrate protrudes on one side of the module may be performed. In various embodiments, the protruding portion of the module substrate (e.g., protruding portion 305) may comprise one elongated grounding pad (e.g., the grounding pad 304).

At operation 1314, applying an adhesive to the module for adhering an EMI shield to the module may be performed.

At operation 1315, applying solder paste to the one elongated grounding pad to create a conductive connection between the module substrate and the EMI shield may be performed.

At operation 1316, coupling the EMI shield to the module may be performed. In various embodiments, the EMI shield may comprise at least one shield component.

At operation 1317, reflowing the solder paste and curing the adhesive may be performed. In various embodiments, the curing may comprise oven curing.

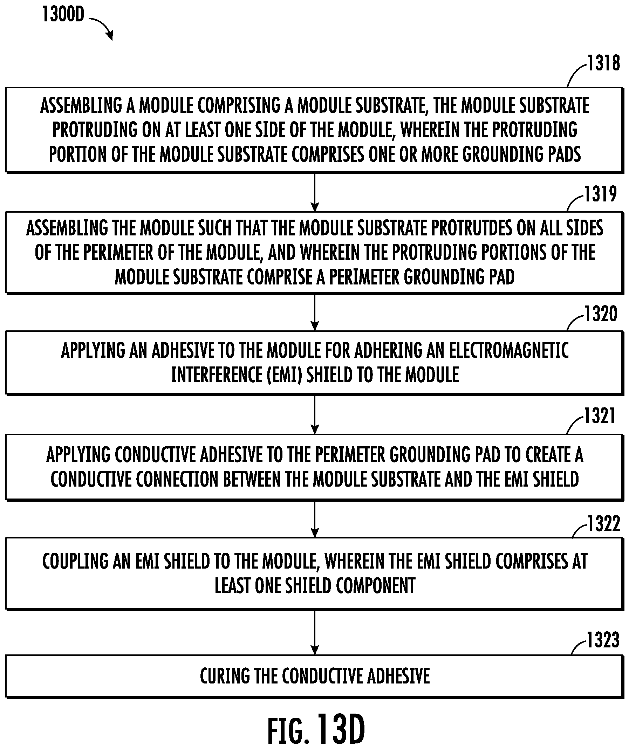

FIG. 13D illustrates an example flowchart 1300D of operations for assembling a module comprising a protruding perimeter of the module substrate and corresponding perimeter grounding pads using conductive adhesive in accordance with one or more embodiments of the present disclosure.

At operation 1318, assembling a module comprising a module substrate may be performed. In various embodiments, the module substrate may protrude on at least one side of the module, wherein the protruding portion of the module substrate may comprise one or more grounding pads.

At operation 1319, assembling the module such that the module substrate protrudes on all sides (e.g., all four sides) of the perimeter of the module is performed. In various embodiments, the protruding portions of the module substrate comprise a perimeter grounding pad.

At operation 1320, applying an adhesive to the module for adhering an EMI shield to the module may be performed. In various embodiments, curing the adhesive may be performed. In various embodiments, the curing may comprise oven curing.

At operation 1321, applying a conductive adhesive to the perimeter grounding pad to create a conductive connection between the module substrate and EMI shield may be performed.

At operation 1322, coupling an EMI shield to the module may be performed. In various embodiments, the EMI shield may comprise at least one shield component.

At operation 1323, curing the adhesive may be performed. In various embodiments, the curing may be oven curing.

In various embodiments, the flowchart 1300D may describe a method such as the one shown in FIG. 5B.

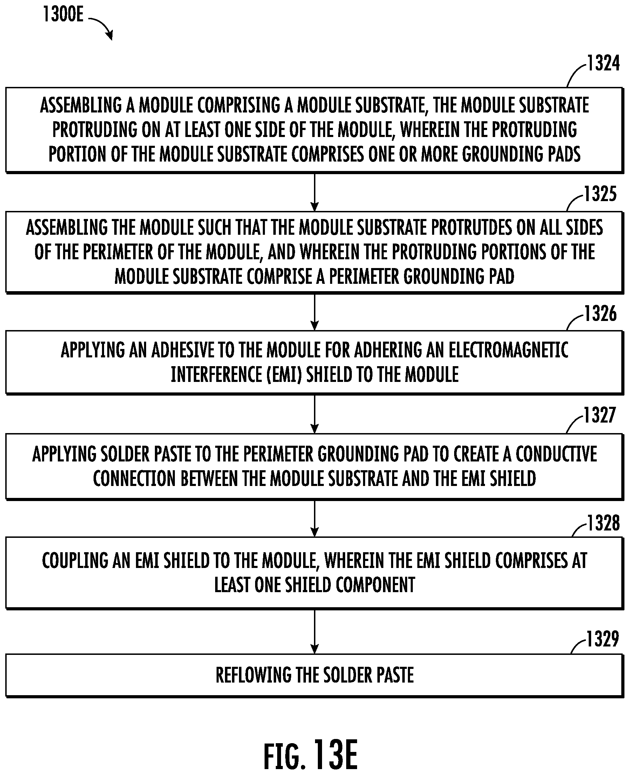

FIG. 13E illustrates an example flowchart 1300E of operations for assembling a module comprising a protruding perimeter of the module substrate and corresponding perimeter grounding pads using solder in accordance with one or more embodiments of the present disclosure.

At operation 1324, assembling a module comprising a module substrate may be performed. In various embodiments, the module substrate may protrude on at least one side of the module, wherein the protruding portion of the module substrate may comprise one or more grounding pads.

At operation 1325, assembling the module such that the module substrate protrudes on all sides (e.g., all four sides) of the perimeter of the module is performed. In various embodiments, the protruding portions of the module substrate comprise a perimeter grounding pad.

At operation 1326, applying an adhesive to the module for adhering an EMI shield to the module may be performed.

At operation 1327, applying solder (e.g., solder paste) to the perimeter grounding pad to create a conductive connection between the module substrate and the EMI shield may be performed.

At operation 1328, coupling an EMI shield to the module may be performed. In various embodiments, the EMI shield may comprise at least one shield component.

At operation 1329, reflowing the solder and curing the adhesive may be performed. In various embodiments, the curing may comprise oven curing.

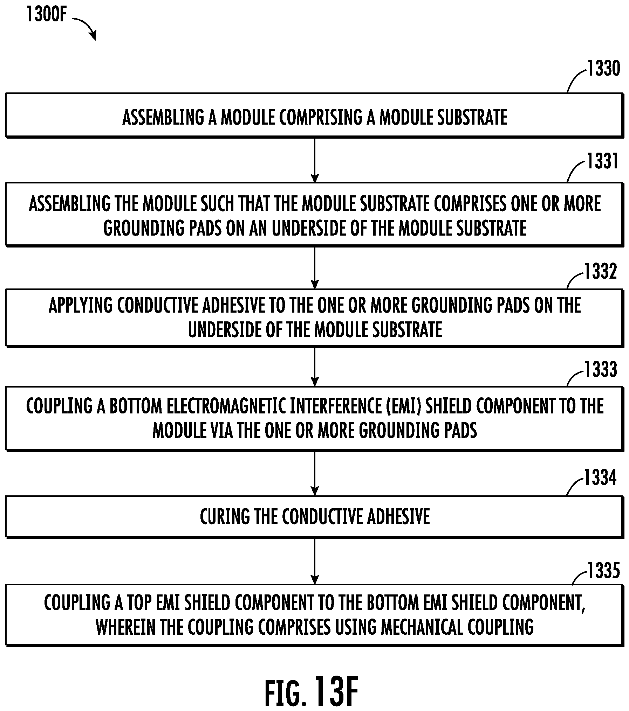

FIG. 13F illustrates an example flowchart 1300F for assembling a module comprising a multi-part EMI shield in accordance with one or more embodiments of the present disclosure.

At operation 1330, assembling a module comprising a module substrate may be performed.

At operation 1331, assembling the module such that the module substrate comprises one or more grounding pads on the underside of the module substrate may be performed.

At operation 1332, applying conductive adhesive to the one or more grounding pads on the underside of the module substrate may be performed.

At operation 1333, coupling a bottom EMI shield component (e.g., the first EMI shield component of FIG. 6) to the module via the one or more grounding pads may be performed.

At operation 1334 curing the conductive adhesive may be performed. In various embodiments, the curing may comprise oven curing.

At operation 1335, coupling a top EMI shield component (e.g., the second EMI shield component of FIG. 6) to the bottom EMI shield component may be performed. In various embodiments, the coupling the top EMI shield component to the bottom EMI shield component may comprise mechanical coupling.

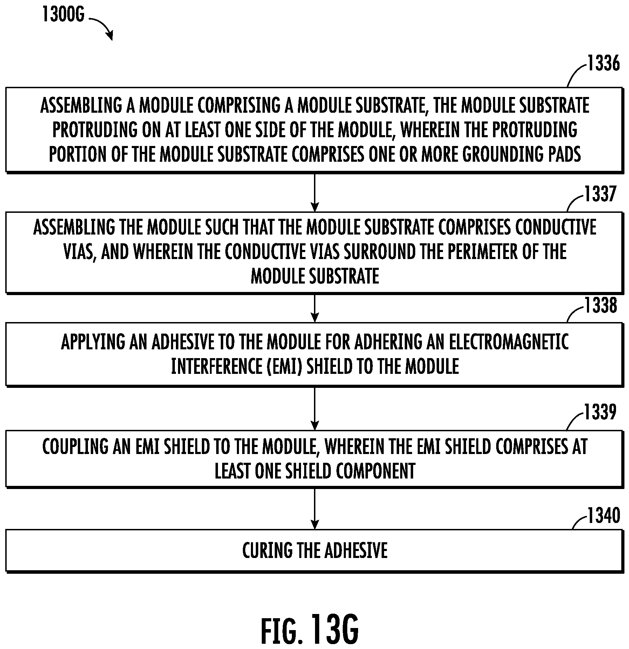

FIG. 13G illustrates an example flowchart 1300G for assembling a module with a substrate comprising conductive vias surrounding its perimeter in accordance with one or more embodiments of the present disclosure.

At operation 1336, assembling a module comprising a module substrate may be performed. In various embodiments, the module substrate may protrude on at least one side of the module, wherein the protruding portion of the module substrate may comprise one or more grounding pads.

At operation 1337 assembling the module such that the module substrate comprises conductive vias extending through the thickness of the substrate may be performed. In various embodiments, the conductive vias may surround the perimeter of the module substrate (e.g., such as shown in FIG. 7A).

At operation 1338, applying an adhesive to the module for adhering an EMI shield to the module may be performed.

At operation 1339, coupling an EMI shield to the module may be performed. In various embodiments, the EMI shield may comprise at least one shield component.

At operation 1340, curing the adhesive may be performed. In various embodiments, the curing may comprise oven curing.

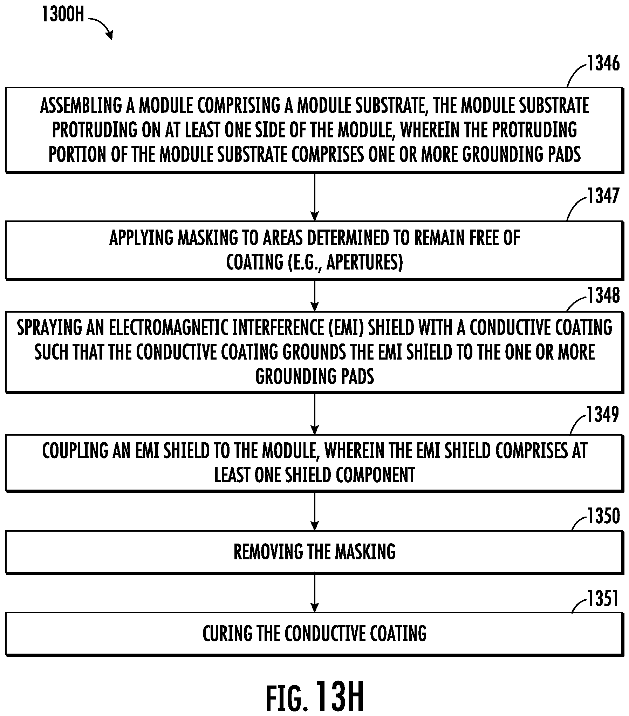

FIG. 13H illustrates an example flowchart 1300I for assembling a module by applying (e.g., spraying) a conductive coating to a module comprising an elongated grounding pad in accordance with one or more embodiments of the present disclosure.

At operation 1346, assembling a module comprising a module substrate may be performed. In various embodiments, the module substrate may protrude on at least one side of the module, wherein the protruding portion of the module substrate comprises one or more grounding pads.

At operation 1347, applying masking to areas determined to remain free of coating may be performed. For example, masking may be applied to apertures of an optical module to prevent coating of the apertures.

At operation 1348, spraying and EMI shield (e.g., the module itself, such as described with respect to FIG. 8) with a conductive coating such that the conductive coating grounds the EMI shield to the one or more grounding pads may be performed. In various embodiments, the conductive coating may be sprayed onto a cap component (e.g., such as described with respect to FIG. 9).

At operation 1349, coupling an EMI shield to the module may be performed. In various embodiments, the EMI shield may comprise at least one shield component.

At operation 1350, removing the masking may be performed.

At operation 1350, curing the conductive coating may be performed.

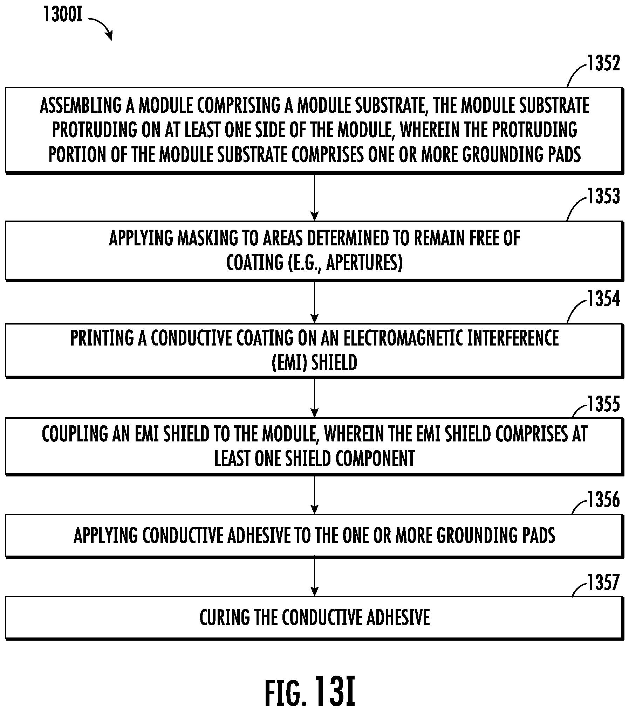

FIG. 13I illustrates an example flowchart 1300J for assembling a module by applying (e.g., printing) a conductive coating to a module comprising an elongated grounding pad and using conductive adhesive in accordance with one or more embodiments of the present disclosure.

At operation 1352, assembling a module comprising a module substrate may be performed. In various embodiments, the module substrate may protrude on at least one side of the module, wherein the protruding portion of the module substrate comprises one or more grounding pads.

At operation 1353, applying masking to areas determined to remain free of coating may be performed. For example, masking may be applied to apertures of an optical module to prevent coating of the apertures. In various embodiments, such as when printing the conductive coating, applying the masking may be omitted.

At operation 1354, printing a conductive coating onto an EMI shield may be performed. In various embodiments, the conductive coating may be printed directly onto the module itself (e.g., such as described with respect to FIG. 8). In various embodiments, the conductive coating may be printed onto a cap component (e.g., such as described with respect to FIG. 9).

At operation 1355, coupling an EMI shield to the module may be performed. In various embodiments, the EMI shield may comprise at least one shield component.

At operation 1356, applying conductive adhesive to the one or more grounding pads may be performed.

At operation 1357, curing the conductive adhesive may be performed. In various embodiments, the curing may comprise oven curing.

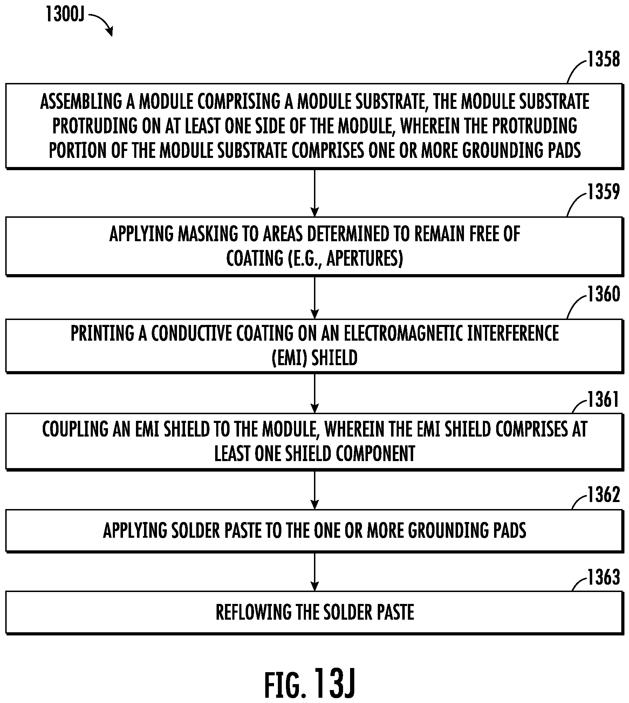

FIG. 13J illustrates an example flowchart 1300K for assembling a module by applying (e.g., printing) a conductive coating to a module comprising an elongated grounding pad and using solder in accordance with one or more embodiments of the present disclosure.

At operation 1358, assembling a module comprising a module substrate may be performed. In various embodiments, the module substrate may protrude on at least one side of the module, wherein the protruding portion of the module substrate comprises one or more grounding pads.

At operation 1359, applying masking to areas determined to remain free of coating may be performed. For example, masking may be applied to apertures of an optical module to prevent coating of the apertures. In various embodiments, such as when printing the conductive coating, applying the masking may be omitted.

At operation 1360, printing a conductive coating onto an EMI shield may be performed. In various embodiments, the conductive coating may be printed directly onto the module itself (e.g., such as described with respect to FIG. 8). In various embodiments, the conductive coating may be printed onto a cap component (e.g., such as described with respect to FIG. 9).

At operation 1361, coupling an EMI shield to the module may be performed. In various embodiments, the EMI shield may comprise at least one shield component.

At operation 1362, applying solder (e.g., solder paste) to the one or more grounding pads may be performed.

At operation 1363, reflowing the solder may be performed.

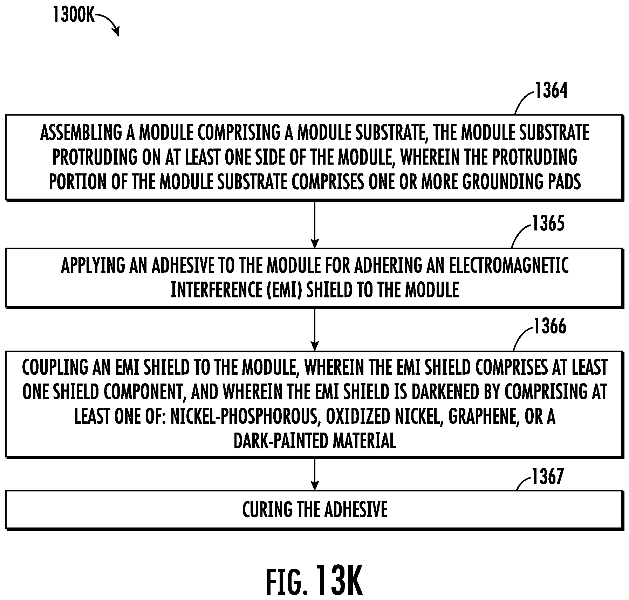

FIG. 13K illustrates an example flowchart 1300L for assembling a module with a darkened EMI shield in accordance with one or more embodiments of the present disclosure.

At operation 1364, assembling a module comprising a substrate may be performed. In various embodiments, the module substrate may protrude on at least one side of the module, wherein the protruding portion of the module substrate may comprise one or more grounding pads.

At operation 1365, applying an adhesive to the module for adhering an EMI shield to the module may be performed.

At operation 1366, coupling an EMI shield to the module may be performed. In various embodiments, the EMI shield may comprise at least one shield component. In various embodiments, the EMI shield may be darkened by comprising at least one of the following: nickel-phosphorous, oxidized nickel, graphene, and/or a dark-painted material.

At operation 1367, curing the adhesive may be performed. In various embodiments, the curing may be oven curing.

Operations and/or functions of the present disclosure have been described herein, such as in flowcharts. As will be appreciated, computer program instructions may be loaded onto a computer or other programmable apparatus (e.g., hardware) to produce a machine, such that the resulting computer or other programmable apparatus implements the operations and/or functions described in the flowchart blocks herein. These computer program instructions may also be stored in a computer-readable memory that may direct a computer, processor, or other programmable apparatus to operate and/or function in a particular manner, such that the instructions stored in the computer-readable memory produce an article of manufacture, the execution of which implements the operations and/or functions described in the flowchart blocks. The computer program instructions may also be loaded onto a computer, processor, or other programmable apparatus to cause a series of operations to be performed on the computer, processor, or other programmable apparatus to produce a computer-implemented process such that the instructions executed on the computer, processor, or other programmable apparatus provide operations for implementing the functions and/or operations specified in the flowchart blocks. The flowchart blocks support combinations of means for performing the specified operations and/or functions and combinations of operations and/or functions for performing the specified operations and/or functions. It will be understood that one or more blocks of the flowcharts, and combinations of blocks in the flowcharts, can be implemented by special purpose hardware-based computer systems which perform the specified operations and/or functions, or combinations of special purpose hardware with computer instructions.

While this specification contains many specific embodiments and implementation details, these should not be construed as limitations on the scope of any disclosures or of what may be claimed, but rather as descriptions of features specific to particular embodiments of particular disclosures. Certain features that are described herein in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

While operations and/or functions are illustrated in the drawings in a particular order, this should not be understood as requiring that such operations and/or functions be performed in the particular order shown or in sequential order, or that all illustrated operations be performed, to achieve desirable results. In certain circumstances, operations and/or functions in alternative ordering may be advantageous. In some cases, the actions recited in the claims may be performed in a different order and still achieve desirable results. Thus, while particular embodiments of the subject matter have been described, other embodiments are within the scope of the following claims.

While this detailed description has set forth some embodiments of the present invention, the appended claims cover other embodiments of the present invention which differ from the described embodiments according to various modifications and improvements.

Within the appended claims, unless the specific term "means for" or "step for" is used within a given claim, it is not intended that the claim be interpreted under 35 U.S.C. § 112, paragraph 6.

## Claims

1. A method for grounding an electromagnetic interference (EMI) shield comprising:
assembling a module comprising a module substrate, the module substrate protruding on at least one side of the module, wherein the protruding portion of the module substrate comprises one or more grounding pads; and
coupling an EMI shield to the module, wherein the EMI shield comprises at least one shield component.

2. The method of claim 1, further comprising:
applying an adhesive to the module for adhering the EMI shield to the module; and
curing the adhesive.

3. The method of claim 1, wherein the module substrate protrudes on one side of the module, and wherein the protruding portion of the module substrate comprises two or more discrete grounding pads.

4. The method of claim 1, wherein the EMI shield comprises discrete cutouts for preventing jetted solder from expanding at unconstraint and resulting in cracking.

5. The method of claim 3, further comprising applying jetted solder to the two or more grounding pads of the module substrate.

6. The method of claim 1, wherein the module substrate protrudes on one side of the module, and wherein the protruding portion of the module substrate comprises one elongated grounding pad.

7. The method of claim 6, further comprising:
applying conductive adhesive to the one elongated grounding pad to create a conductive connection between the module substrate and the EMI shield; and
curing the conductive adhesive.

8. The method of claim 6, further comprising:
applying solder paste to the one elongated grounding pad to create a conductive connection between the module substrate and the EMI shield; and
reflowing the solder paste.

9. The method of claim 1, wherein the module substrate protrudes on all sides of the perimeter of the module, and wherein the protruding portions of the module substrate comprise a perimeter grounding pad.

10. The method of claim 9, further comprising:
applying conductive adhesive to the perimeter grounding pad to create a conductive connection between the module substrate and the EMI shield; and
curing the conductive adhesive.

11. The method of claim 9, further comprising:
applying solder paste to the perimeter grounding pad to create a conductive connection between the module substrate and the EMI shield; and
reflowing the solder paste.

12. The method of claim 1, wherein the module substrate comprises one or more grounding pads on an underside of the module substrate.

13. The method of claim 12, further comprising:
applying conductive adhesive to the one or more grounding pads on the underside of the module substrate;
coupling a bottom EMI shield component to the module via the one or more grounding pads;
curing the conductive adhesive; and
coupling a top EMI shield component to the bottom EMI shield component.

14. The method of claim 13, wherein the coupling the top EMI shield component to the bottom EMI shield component comprises using mechanical coupling.

15. The method of claim 1, wherein the module substrate comprises grounded conductive vias which span across the thickness of the module substrate and wherein the conductive vias surround the perimeter of the module substrate.

16. The method of claim 1, further comprising:
applying masking to areas determined to remain free of coating;
spraying the EMI shield with a conductive coating such that the conductive coating grounds the EMI shield to the one or more grounding pads;
removing the masking; and
curing the conductive coating.

17. The method of claim 1, further comprising using a darkened EMI shield, wherein the darkened EMI shield is comprised of at least one of:
nickel-phosphorous;
oxidized nickel;
graphene; or
dark-painted material.

18. A system comprising:
an optical module comprising:
one or more optical components;
an optical module substrate, wherein the optical module substrate protrudes on at least one side of the module, wherein the protruding portion of the module substrate comprises one or more grounding pads; and
an EMI shield, wherein the EMI shield comprises at least one shield component.

19. The system of claim 18, wherein the EMI shield is coupled to the optical module substrate via at least one of:
conductive adhesive;
solder paste; or
jetted solder.

20. The system of claim 18, wherein the optical module substrate comprises grounded conductive vias which span across the thickness of the optical module substrate and wherein the conductive vias surround the perimeter of the optical module substrate.
